(19) Europäisches Patentamt / European Patent Office / Office européen des brevets

(11) **EP 4 317 363 A1**

(12) **EUROPEAN PATENT APPLICATION**
published in accordance with Art. 153(4) EPC

(43) Date of publication:
**07.02.2024 Bulletin 2024/06**

(21) Application number: **21935182.2**

(22) Date of filing: **10.12.2021**

(51) International Patent Classification (IPC):
*C09K 11/08* (2006.01)     *C09K 11/62* (2006.01)

(52) Cooperative Patent Classification (CPC):
**C09K 11/08; C09K 11/62**

(86) International application number:
**PCT/JP2021/045661**

(87) International publication number:
**WO 2022/209033 (06.10.2022 Gazette 2022/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.03.2021 JP 2021056337**

(71) Applicant: **Mitsui Mining & Smelting Co., Ltd.**
**Shinagawa-ku**
**Tokyo 141-8584 (JP)**

(72) Inventors:
• **SASAKURA, Asuka**
  **Ageo-shi, Saitama 362-0021 (JP)**
• **INAMURA, Masaaki**
  **Ageo-shi, Saitama 362-0021 (JP)**
• **OZAWA, Ikuhiro**
  **Ageo-shi, Saitama 362-0021 (JP)**

(74) Representative: **Novagraaf Technologies**
**Bâtiment O2**
**2, rue Sarah Bernhardt**
**CS90017**
**92665 Asnières-sur-Seine Cedex (FR)**

Remarks:
A request for correction of the description has been filed pursuant to Rule 139 EPC. A decision on the request will be taken during the proceedings before the examining division (Guidelines for Examination in the EPO, A-V, 3).

(54) **PHOSPHOR, METHOD FOR PRODUCING SAME, LIGHT EMITTING ELEMENT CONTAINING PHOSPHOR, AND LIGHT EMITTING DEVICE**

(57)     A phosphor contains: a crystal represented by $MGa_2S_4$, where M includes at least one element selected from the group consisting of Ba, Sr, and Ca; and an element A that functions as a luminescent center, wherein diffraction peaks are observed in a range of $2\theta = 27.6°$ or more and 28.3° or less and a range of $2\theta = 28.45°$ or more and 28.75° or less in an X-ray diffraction pattern obtained through measurement that uses $CuK\alpha$ rays performed using an X-ray diffractometer. A method for producing a phosphor includes sintering an ingredient composition that contains a gallium element (Ga), a sulfur element (S), an element M, where the element M includes at least one selected from the group consisting of Ba, Sr, and Ca and an element A that functions as a luminescent center while a portion of the ingredient composition is melted. The present invention also provides a light emitting device including: a light emitting element that contains the above-described phosphor; and an excitation source.

Fig. 1

## Description

## Technical Field

The present invention relates to a phosphor and a method for producing the same. The present invention also relates to a phosphor-containing light emitting element and a light emitting device.

## Background Art

Various types of light emitting devices have been developed such as, for example, a light emitting device that that has a wide color reproduction range and in which a blue light emitting diode (LED), which is used as a light source, is combined with a phosphor that emits green fluorescent light or a phosphor that emits red fluorescent light. For example, as the phosphor that emits green fluorescent light, the applicant of the present application has previously proposed sulfides in Patent Literatures 1 and 2.

## Citation List

Patent Literature

Patent Literature 1: U.S. Patent Application Publication No. 2011/114985
Patent Literature 2: U.S. Patent Application Publication No. 2012/018674

## Summary of Invention

The external quantum efficiency of a phosphor is expressed by a product obtained by multiplying absorption rate by internal quantum efficiency. Accordingly, the emission intensity of the phosphor can be increased by increasing the internal quantum efficiency of the phosphor. The phosphors disclosed in Patent Literatures 1 and 2 mentioned above have a high internal quantum efficiency. However, the current demand requires a light emitting display device with high brightness and low power consumption, and thus a phosphor that has an internal quantum efficiency higher than conventional phosphors is required.

Accordingly, it is an object of the present invention to provide a phosphor that has an internal quantum efficiency higher than conventional phosphors, and a method for producing the same.

The present invention provides a phosphor including:

a crystal phase represented by a formula (1): $MGa_2S_4$, where M includes at least one element selected from the group consisting of Ba, Sr, and Ca;
a crystal phase represented by a formula (2): $MGa_4S_7$, where M includes at least one element selected from the group consisting of Ba, Sr, and Ca; and
an element A that functions as a luminescent center.

Also, the present invention provides a method for producing a phosphor, the method comprising:

preparing an ingredient composition that contains Ga, S, and M; and
an element A that functions as a luminescent center,
where M includes at least one element selected from the group consisting of Ba, Sr, and Ca, and

sintering the ingredient composition while a portion of the ingredient composition is melted.

Also, the present invention provides a method for producing a phosphor, the method comprising:

preparing an ingredient composition that contains Ga, S, and M; and
an element A that functions as a luminescent center,
where M includes at least one element selected from the group consisting of Ba, Sr, and Ca, and
sintering the ingredient composition to produce a compound represented by a formula (1): $MGa_2S_4$,

where M includes at least one selected from the group consisting of Ba, Sr, and Ca and a compound represented by a formula (2): $MGa_4S_7$, where M includes at least one element selected from the group consisting of Ba, Sr, and Ca.

**Brief Description of Drawings**

[Fig. 1] Fig. 1 is an X-ray diffraction chart of a phosphor produced in Example 1.
[Fig. 2] Fig. 2 is an X-ray diffraction chart of a phosphor produced in Example 2.
[Fig. 3] Fig. 3 is an X-ray diffraction chart of a phosphor produced in Example 3.
[Fig. 4] Fig. 4 is an X-ray diffraction chart of a phosphor produced in Comparative Example 1.

**Description of Embodiment**

Hereinafter, the present invention will be described based on a preferred embodiment thereof. A phosphor according to the present invention contains a crystal of a sulfide that contains gallium (Ga), sulfur (S), and a predetermined metal element (hereinafter, this element will be represented by M).

The phosphor has a crystal structure of a compound represented by a formula (1): $MGa_2S_4$, where M includes at least one element selected from the group consisting of barium (Ba), strontium (Sr), and calcium (Ca). By containing at least one element selected from the group consisting of Ba, Sr, and Ca as the element M, the color of emitted light can be easily adjusted.

The crystal phase derived from the formula (1) may be a major phase or a minor phase in the phosphor, and is preferably a major phase in the phosphor. The term "major phase" used in the description of the present application refers to, in the phosphor as a whole, a phase to which a maximum peak in an X-ray diffraction pattern is attributed. In addition, the term "minor phase" used in the description of the present application refers to a crystal phase other than the major phase.

Unless otherwise stated, the element M in the description of the present application refers to a monovalent or divalent metal element. Preferred examples of elements encompassed by the element M include divalent metal elements such as Zn in addition to the above-described elements including Ba, Sr, and Ca. Also, unless otherwise stated, the description of the element M is applied throughout the description of the present application.

As the element M described above, it is more preferable that the crystal structure represented by the formula (1) is a crystal structure of a compound represented by a formula (1a): $(Ba_{1-x}Sr_x)Ga_2S_4$, where x is preferably 0.5 or more and 1 or less, and more preferably 0.6 or more and 0.95 or less. By having the crystal structure described above, it is possible to increase the internal quantum efficiency to a high level. In addition thereto, for example, when this phosphor is used as the material for making a color image display device that uses three primary colors including red, green, and blue, it is possible to display green with a high saturation, or in other words, green with a high color purity on the color image display device.

Whether or not the phosphor has the crystal structure of the compound represented by the formula: $MGa_2S_4$ can be determined by, for example, determining whether characteristic diffraction peaks are observed in the following ranges of $2\theta = 16.93° \pm 0.5°$, $23.98° \pm 0.5°$, $29.88° \pm 0.5°$, $34.24° \pm 0.5°$, and $38.31° \pm 0.5°$ in a diffraction pattern obtained through X-ray diffractometry that uses CuKα rays. For identification of the diffraction peaks derived from the crystal structure, it is possible to use, for example, PDF data No. 01-077-1189 or 00-025-0895 can be used.

The phosphor preferably exhibits diffraction peaks in a range of $2\theta = 27.55°$ or more and $28.30°$ or less and a range of $2\theta = 28.45°$ or more and $28.75°$ or less. That is, it is preferable that, in one particle of the phosphor, the above-described diffraction peaks are also observed in addition to the diffraction peaks derived from $MGa_2S_4$ that is the major phase.

It has been found that the above-described diffraction peaks are not observed in a pure crystal of $MGa_2S_4$, but, by using a phosphor that exhibits the above-described diffraction peaks, the phosphor has a high internal quantum efficiency while having the same level of light absorption rate as conventional phosphors. The crystal structure described above can be obtained using, for example, a production method described later.

The phosphor preferably has a crystal structure represented by a formula (2): $MGa_4S_7$ in addition to the crystal structure represented by the formula (1). That is, it is preferable that one particle of the phosphor includes a crystal phase represented by the formula (1) and a crystal phase represented by the formula (2). In the formula (2), M includes at least one selected from the group consisting of Ba, Sr, and Ca. The crystal phase derived from the formula (2) may be a major phase or a minor phase in the phosphor, and is preferably a minor phase in the phosphor.

By having the crystal structure represented by the formula (2), it is more likely to obtain a phosphor that has a high internal quantum efficiency while having the same level of light absorption rate as conventional phosphors, and also has a high light emission efficiency, and in which the crystal phase of $MGa_2S_4$ that has a high external quantum efficiency can be easily obtained.

Whether or not the phosphor has the crystal structure of the compound represented by the formula $MGa_4S_7$ can be determined by, for example, determining whether characteristic diffraction peaks are observed in a range of $2\theta$

= 27.55°or more and 28.30° or less and a range of 2θ = 28.45°or more and 28.75° or less in a diffraction pattern obtained through X-ray diffractometry that uses CuKα rays. For identification of the diffraction peaks derived from the crystal structure, it is possible to use, for example, PDF data No. 01-077-8955.

In the crystal structure represented by $MGa_2S_4$ contained in the phosphor according to the embodiment described above, in the case where the element M is a divalent element, the stoichiometric ratio can be expressed by 2 mols of Ga relative to 1 mol of the element M. In the case where the element M is a divalent element, a ratio $X_{Ga}/(X_M + X_A)$ is preferably within a predetermined range, where the molar amounts of the element M, an element A that is a light emitting element, which will be described later, and Ga contained in the phosphor of the present invention are represented by $X_M$, $X_A$, and Xca, respectively, and the ratio $X_{Ga}/(X_M + X_A)$ is the ratio of the molar amount $X_{Ga}$ of Ga relative to the sum $(X_M + X_A)$ of the molar amount of the element M and the molar amount of the element A that is a light emitting element.

Specifically, the ratio $X_{Ga}/(X_M + X_A)$ is preferably 1.6 or more and 2.6 or less, more preferably 1.7 or more and 2.5 or less, even more preferably 1.8 or more and 2.4 or less, and even much more preferably 2.05 or more and 2.35 or less. When the ratio $X_{Ga}/(X_M + X_A)$ is within the above-described range, it is possible to reduce the melting point, facilitate the step of sintering an ingredient composition while a portion of the ingredient composition is melted, and obtain a phosphor that has a high internal quantum efficiency at a high productivity. The ratio $X_{Ga}/(X_M + X_A)$ can be adjusted as appropriate by, for example, adjusting the amount of the ingredient composition that contains the element M, the element A, and Ga used to produce the phosphor.

In the phosphor, it is preferable that the ratio of predetermined diffraction peaks is within a specific range in a diffraction pattern obtained through X-ray diffractometry that uses CuKα rays.

Specifically, when a maximum diffraction peak value observed in a range of 2θ = 27.9°or more and 28.36° or less is represented by Ia, and a maximum diffraction peak value observed in a range of 2θ = 25.8°or more and 26.1° or less is represented by Ic. At this time, a ratio Ia/Ic, which is the ratio of Ia relative to Ic, is preferably 0.4 or more, more preferably 1.0 or more, and even more preferably 1.2 or more. Also, the ratio Ia/Ic is preferably 50 or less, more preferably 10 or less, and even more preferably 5 or less.

The diffraction peak based on which Ia is determined is presumed to be derived from $MGa_4S_7$, and the diffraction peak based on which Ic is determined is presumed to be derived from $M_2Ga_2S_5$. Accordingly, when the ratio Ia/Ic of diffraction peaks derived from the crystal phases is within the above-described range, it means that a phosphor is produced in an environment where a large amount of the crystal phase of $MGa_2S_4$ described above is produced, and it is therefore likely to obtain a phosphor that has a high internal quantum efficiency, and in which the crystal phase of $MGa_2S_4$ that is likely to exhibit a high external quantum efficiency can be easily obtained, and that also exhibits a high light emission efficiency.

The term "maximum diffraction peak value" used in the description of the present application means a maximum value of X-ray diffraction intensity obtained in the above-described diffraction angle range in the X-ray diffractometry.

Also, when a maximum diffraction peak value observed in a range of 2θ = 28.4°or more and 28.86° or less is represented by Ib, and a maximum diffraction peak value observed in a range of 2θ = 25.8°or more and 26.1° or less is represented by Ic, a ratio Ib/Ic, which is the ratio of Ib relative to Ic, is preferably 0.4 or more, more preferably 0.5 or more, and even more preferably 0.8 or more. Also, the ratio Ib/Ic is preferably 50 or less, more preferably 10 or less, and even more preferably 5 or less.

The diffraction peak based on which Ib is determined is presumed to be derived from $MGa_4S_7$. Accordingly, when the ratio Ib/Ic of diffraction peaks derived from the crystal phases is within the above-described range, it means that a phosphor is produced in an environment where a large amount of the crystal phase of $MGa_2S_4$ described above is produced, and it is therefore likely to obtain a phosphor that has a high internal quantum efficiency, and in which the crystal phase of $MGa_2S_4$ that is likely to exhibit a high external quantum efficiency can be easily obtained, and that also exhibits a high light emission efficiency.

Also, when a maximum diffraction peak value observed in a range of 2θ = 28.4°or more and 28.86° or less is represented by Ib, and a maximum diffraction peak value observed in a range of 2θ = 27.3°or more and 27.8° or less is represented by Id, a ratio Ib/Id, which is the ratio of Ib relative to Id, is preferably 1.8 or more, and more preferably 2.0 or more. Also, the ratio Ib/Id is preferably 50 or less, more preferably 10 or less, and even more preferably 5 or less.

The diffraction peak based on which Id is determined is presumed to be derived from $M_2Ga_2S_5$. Accordingly, when the ratio Ib/Id of diffraction peaks derived from the crystal phases is within the above-described range, it means that a phosphor is produced in an environment where a large amount of the crystal phase of $MGa_2S_4$ described above is produced, and it is therefore likely to obtain a phosphor that has a high internal quantum efficiency, and in which the crystal phase of $MGa_2S_4$ that is likely to exhibit a high external quantum efficiency can be easily obtained, and that also exhibits a high light emission efficiency.

It is more preferable that, in the phosphor, a crystal phase represented by a formula (3): $M_2Ga_2S_5$ is not observed. In the formula (3), M includes at least one selected from the group consisting of Ba, Sr, and Ca. When the crystal phase represented by $M_2Ga_2S_5$ is not observed, it means that a phosphor is produced in an environment where a large amount of the crystal phase of $MGa_2S_4$ described above is produced, and it is therefore likely to obtain a phosphor material that has a high internal quantum efficiency, and in which the crystal phase of $MGa_2S_4$ that is likely to exhibit a high external quantum efficiency can be easily obtained, and that also has a high light emission efficiency.

Whether or not the phosphor has the crystal phase represented by $M_2Ga_2S_5$ can be determined by, for example, determining whether characteristic diffraction peaks are observed in a range of $2\theta = 25°$ or more and $27°$ or less and a range of $2\theta = 32°$ or more and $34°$ or less in a diffraction pattern obtained through X-ray diffractometry that uses $CuK\alpha$ rays. For identification of the diffraction peaks derived from the crystal structure, it is possible to use, for example, PDF data No. 00-047-1130.

The X-ray diffraction patterns obtained through X-ray diffractometry that uses $CuK\alpha$ rays in the description of the present application can be obtained, for example, under the following measurement conditions.

- Device: Rigaku ULITIMA IV
- X-ray tube: $CuK\alpha$
- X-ray tube voltage: 50 kV
- X-ray tube current: 300 mA
- Measurement diffraction angle: $2\theta = 10$ to $80°$
- Measurement step width: $0.01°$
- Collection time: $2°$/min
- Detector: High-speed one-dimensional X-ray detector D/teX Ultra 250
- Light receiving slit width: 0.3 mm
- Divergence slit: 2/3°
- Divergence vertical limit slit width: 10 mm (using a $K\beta$ filter)

The phosphor preferably contains, in addition to the elements described in the embodiment given above, at least one element selected from the group consisting of europium (Eu), cerium (Ce), manganese (Mn), and samarium (Sm) as the element A that functions as a luminescent center in the phosphor. From the viewpoint of further increasing the internal quantum efficiency upon excitation by blue light emitted from an LED, the phosphor preferably contains Eu, more preferably contains divalent ions of Eu (or in other words, $Eu^{2+}$), and even more preferably contains only $Eu^{2+}$ among the elements that can function as the luminescent center.

As the ratio of the luminescent center in the phosphor, from the viewpoint of further improving the emission intensity, the ratio ($X_A/(X_M + X_A)$), which is the ratio of the molar amount $X_A$ of the element relative to the sum ($X_M + X_A$) of the molar amount of the element M and the molar amount of the element A that is a light emitting element contained in the phosphor is preferably 0.05 or more, more preferably 0.07 or more, and even more preferably 0.1 or more. Also, from the viewpoint of preventing concentration quenching from occurring, the ratio $X_A/(X_M + X_A)$ is preferably 0.3 or less, more preferably 0.25 or less, and even more preferably 0.2 or less.

The phosphor of the present invention is excited by light with a wavelength in a wavelength range of 250 nm or more and 510 nm or less, and has a light emission peak in a wavelength range of 420 nm or more and 730 nm or less. Specifically, the phosphor is excited by, for example, light with a wavelength of around 450 nm emitted from a blue LED, and illuminates by emitting visible light in a range of green to yellow.

Hereinafter, an embodiment of a preferred production method for producing a phosphor will be described. The production method of the present invention includes sintering an ingredient composition that contains Ga, S, M, where M includes at least one element selected from the group consisting of Ba, Sr, and Ca, and an element A that functions as a luminescent center.

First, an ingredient composition that contains an element Ga, an element S, an element M, and an element A that functions as a luminescent center is prepared. As the ingredient composition, these elements can be used alone or in the form of a compound or a mixture. The ingredient composition is typically in the form of a solid.

Examples of a Ga-containing ingredient include an element Ga alone and compounds such as $Ga_2O_3$ and $Ga_2S_3$.

Examples of an S-containing ingredient include an element S alone and compounds such as $H_2S$ gas, $CS_2$, and $Ga_2S_3$.

Examples of an M-containing ingredient include an element M alone and an oxide, a hydroxide, a sulfide, a sulfate, a carbonate, and the like of the element M such as MS, $MSO_4$, $MCO_3$, $M(OH)_2$, and MO, a Ba-containing compound, an Sr-containing compound, and a Ca-containing compound.

Examples of a luminescent center element A-containing ingredient include an oxide, a sulfide, a halide, and various types of salts of the element A. Here, examples of an Eu-containing ingredient that can be used as the element A that functions as a luminescent center include $Eu_2O_3$, EuS, $EuF_3$, $EuCl_3$, and the like. Also, examples of a Ce-containing ingredient that can be used as the element A that functions as a luminescent center include $CeO_2$, $Ce_2S_3$, $CeF_3$, $CeCl_3$, and the like. Examples of an Mn-containing ingredient that can be used as the element A that functions as a luminescent center include $MnO_2$, $Mn_2S_3$, $MnF_3$, $MnCl_3$, and the like. Examples of an Sm-containing ingredient that can be used as the element A that functions as a luminescent center include $Sm_2O_3$, $Sm_2S_3$, $SmF_3$, $SmCl_3$, and the like.

The ingredient composition can be obtained by dry or wet mixing the above-described ingredients, or subjecting the above-described ingredients to wet synthesis in a liquid.

The dry mixing can be performed using, for example, a mixing device such as a paint shaker or a ball mill.

The wet mixing can be performed by suspending the ingredients in a liquid medium to obtain a suspension, and introducing the obtained suspension into a mixing device as described above. After that, the obtained mixture is subjected to solid-liquid separation using a sieve or the like to obtain a solid, and the obtained solid is dried to obtain the intended ingredient composition. As the liquid medium, a solvent that evaporates under heating conditions, which will be described later, such as alcohol including ethanol and liquid nitrogen can be used.

In the case where the ingredient composition is subjected to wet synthesis in a liquid, the ingredient composition can be obtained by: obtaining a precursor using any of various production methods such as, for example, a sol gel method, a citric acid complex method, a citric acid complex polymerization method, a coprecipitation method, a metal hydroxide precipitation method, a homogeneous precipitation method, an inorganic salt hydrolysis method, an alkoxide method, a redox method, a hydrothermal method, an emulsion method, a solvent evaporation method, and an anti-solvent dilution method; and then bringing the precursor into contact with a sulfur-containing gas such as $H_2S$ or $CS_2$ to sulfurize the precursor.

From the viewpoint of being able to efficiently obtain a crystal that has the above-described X-ray diffraction pattern to increase the internal quantum efficiency, it is preferable to mix the Ga-containing ingredient, the M-containing ingredient, and the luminescent center element A-containing ingredient such that the ratio $X_{Ga}/(X_M + X_A)$, where the molar amounts of the element M, the element A, and Ga contained in the phosphor are represented by $X_M$, $X_A$, and $X_{Ga}$, respectively, is preferably 1.6 or more and 2.6 or less, more preferably 1.7 or more and 2.5 or less, even more preferably 1.8 or more and 2.4 or less, and even much more preferably 2.05 or more and 2.35 or less. The molar ratio of the Ga-containing ingredient, the M-containing ingredient, and the luminescent center element A-containing ingredient at the time of preparation roughly matches the molar ratio of Ga, M, and the luminescent center element A contained in the obtained phosphor. For this reason, by mixing the ingredients at a molar ratio within the above-described range, the above-described characteristic diffraction peaks can be easily exhibited and the ratio $X_{Ga}/(X_M + X_A)$ can be easily achieved, and thus a phosphor that has an even higher internal quantum efficiency can be obtained at a high productivity.

Next, the ingredient composition described above is sintered. In the production method of the present invention, the ingredient composition in the form of a solid may be sintered while a portion of the ingredient composition is melted.

Through sintering as described above, it is possible to produce a phosphor material that has, in one particle, a crystal structure represented by the formula (1): $MGa_2S_4$ and preferably a crystal structure represented by the formula (2): $MGa_4S_7$, and obtain a phosphor that has an even higher internal quantum efficiency at a high productivity.

The sintering temperature used to sinter the ingredient composition may be changed as appropriate according to the abundance ratio of each ingredient. However, from the viewpoint of improving crystallinity, it is preferable to sinter the ingredient composition at a higher temperature. Specifically, the sintering temperature is preferably 1000°C or more and 1400°C or less, more preferably 1100°C or more and 1300°C or less, and even more preferably 1150°C or more and 1250°C or less.

From the viewpoint of efficiently producing a compound represented by the formula (1): $MGa_2S_4$ and a compound represented by the formula (2): $MGa_4S_7$ to easily obtain a phosphor that has an excellent internal quantum efficiency, it is preferable to perform sintering to produce $MGa_2S_4$ and then convert the produced $MGa_2S_4$ into $MGa_4S_7$.

As one embodiment of temperature conditions for sintering the ingredient composition as described above, for example, the temperature increase rate during sintering is set to preferably 1°C/min or more and 10°C/min or less, more preferably 2°C/min or more and 8°C/min or less, and even more preferably 3°C/min or more and 7°C/min or less. After the target sintering temperature is reached, sintering is performed for preferably 1 hour or more and 12 hours or less, more preferably 2 hours or more and 10 hours or less, and even more preferably 3 hours or more and 8 hours or less while maintaining the sintering temperature.

In the case where the above-described ingredient composition is used, $MGa_2S_4$ is likely to be produced in a temperature range of about 500 to 900°C, and $MGa_4S_7$ is likely to be produced in a temperature range of 1000°C or more. By performing sintering using the temperature increase rate, the temperature, and the time described above, a portion of $MGa_2S_4$ can be easily converted into $MGa_4S_7$, and a phosphor that has an even higher internal quantum efficiency is more likely to be obtained. In addition thereto, it is advantageous to set the molar ratio of Ga relative to the molar ratio of the element M in the ingredient composition to be higher than the stoichiometric ratio of $MGa_2S_4$ because the ratio $X_{Ga}/(X_M + X_A)$ is likely to be greater than 2, and it is possible to more efficiently produce $MGa_4S_7$ that contributes to improvement of the internal quantum efficiency.

As the sintering atmosphere, an inert gas such as nitrogen, carbon dioxide, or argon, a reducing gas such as hydrogen gas, a sulfur-containing gas such as hydrogen sulfide or carbon disulfide, or the like can be used. Preferably, a sulfur-containing gas is used. By sintering the ingredient composition while introducing a sulfur-containing gas, even when the ingredient composition contains no sulfur or the ingredient composition contains sulfur in an amount smaller than the stoichiometric ratio, the ingredient composition can be reacted with the sulfur contained in the gas to obtain the intended product at a high productivity. In addition thereto, sintering the ingredient composition while introducing a sulfur-containing gas is also advantageous in terms of suppressing unintended decomposition of the product.

Gallium sulfide may be added to the sintered product obtained through sintering as described above, and then further sintered. Through this, $MGa_4S_7$ is more likely to be produced. The sintering temperature and the sintering time used at this time may be the same as those described above.

The product obtained through the above-described steps is in the form of a lump, a granule, or a powder. The obtained product may be used as the phosphor of the present invention. Instead of this, the product obtained through the above-described steps may be subjected to post-processing steps such as crushing or classification using a sieve, a mill, a liquid, or the like, an annealing process, and a coating process as needed to obtain the intended phosphor.

In the case where crushing is performed, it is preferable to perform crushing using a stamp mill, a paint shaker, a grinder, or the like under mild conditions that do not affect the crystal structure.

In the case where classification is performed, from the viewpoint of enhancing the ease of handling and the light emission properties of the obtained phosphor, classification is performed such that the product has a particle size of preferably 0.01 $\mu$m or more and 150 $\mu$m or less, and more preferably 1 $\mu$m or more and 50 $\mu$m or less. The term "particle size" as used herein refers to a cumulative volume particle size at 50% cumulative volume obtained using a laser diffraction scattering particle size distribution measurement method.

In the case where classification is performed using a liquid, the product is dispersed in a dispersion medium through ultrasonic treatment or the like, and then settled. Then, the settled solid is recovered and dried. As the dispersion medium, water or an organic solvent such as ethanol can be used.

The product that has undergone crushing or classification may be further subjected to an annealing process to obtain the intended phosphor. As the conditions for the annealing process, the temperature and the time described above as the sintering conditions and the molar ratio condition described above can be used as appropriate.

In the case where a coating process is performed, from the viewpoint of maintaining favorable light emission properties of the phosphor while improving the durability of the phosphor such as moisture resistance, it is preferable to coat the surface of the phosphor with at least one of inorganic compounds including $SiO_2$, $ZnO$, $Al_2O_3$, $TiO_2$, an oxide that contains boron, a metal sulfate such as $BaSO_4$, and the like.

The phosphor obtained through the above-described steps is preferably in the form of a powder composed of an aggregate of phosphor particles. This phosphor can be used to obtain a light emitting element, or a light emitting device that includes one or more light emitting elements and one or more excitation sources. More specifically, the light emitting element can also be used as, for example, a lighting member, a window member, an electric illumination member, a light guiding member, a general lighting member such as a projector screen, an image display device such as a light emitting display, a liquid crystal television set, a personal computer, a mobile device such as a tablet or a smartphone, an LED element of lighting equipment or the like, or a constituent member of a light emitting device that includes an excitation source such as a $\mu$LED element.

A light emitting element includes a phosphor and a resin. The light emitting element can be obtained by, for example, adding phosphor particles to a melted resin, kneading them, and molding the resulting mixture into a predetermined shape using an inflation method, a T-die method, a calender method, or the like.

Instead of this, a light emitting element may be formed directly on an excitation source by placing, on the surface of the excitation source, a liquid mixture that contains, in addition to a phosphor and a resin, an organic solvent in which the phosphor and the resin can be dispersed. The liquid mixture applied onto a device is applied or sprayed using any type of printing method such as screen printing, gravure printing, offset printing, or flexography using a bar, a roller, a spray gun, or the like, and then the solvent is dried.

As the resin that constitutes the light emitting element, for example, a thermoplastic resin, a thermosetting resin, an ionizing radiation curable resin, or a two-part mixture curable resin can be used.

Examples of the thermoplastic resin include: polyolefin-based resins such as polyethylene and polypropylene; polyester-based resins such as polyethylene terephthalate and polybutylene terephthalate; polycarbonate resins; polyacrylic acid-based resins such as polyacrylic acid, an ester thereof, polymethacrylic acid, and an ester thereof; polyvinyl-based resins such as polystyrene and polyvinyl chloride; cellulose-based resins such as triacetyl cellulose; urethane resins such as polyurethane; and the like.

Also, examples of the thermosetting resin include a silicone resin, a phenol resin, an epoxy resin, a melamine resin, a urea resin, an unsaturated polyester resin, an alkyd resin, a polyurethane resin, a polyimide resin, and the like. Examples of the ionizing radiation curable resin include an acrylic resin, a urethane resin, a vinyl ester resin, a polyester alkyd resin, and the like. These resins can be used not only as polymers, but also as oligomers or monomers. An example of the two-part mixture curable resin may be an epoxy resin.

**Examples**

Hereinafter, the present invention will be described in further detail based on examples. However, the scope of the present invention is not limited to the examples given below. In the table given below, the cells with a sign "-" indicate that measurement or evaluation was not carried out.

Examples 1 to 3 and Comparative Examples 1 and 2

BaS and SrS were prepared as element M-containing ingredients, EuS was prepared as a luminescent center element A-containing ingredient, and $Ga_2S_3$ was prepared as a Ga-containing ingredient. The ingredients were weighed such that the elements were contained at a molar ratio shown in Table 1 given below, and then the ingredients were mixed for 100 minutes in a paint shaker using zirconia balls with a diameter $\varphi$ of 3 mm to obtain an ingredient composition.

The obtained ingredient composition was sintered in an $H_2S$ atmosphere at a temperature increase rate of 5°C/min and a sintering temperature shown in Table 1 given below for a sintering time of 6 hours to obtain a product. In each example, the product was obtained by sintering the ingredient composition while a portion of the ingredient composition was melted. Then, the product was crushed for 1 minute using a grinder (ALM-360T available from Nitto Kagaku Co., Ltd.), classified using a 140 mesh sieve and a 440 mesh sieve, and then recovered at a position under the 140 mesh sieve and above the 440 mesh sieve to obtain the intended phosphor in the form of a powder.

In Comparative Example 2, the entire ingredient composition was melted, and thus it was not possible to obtain the intended phosphor. For this reason, evaluation was not carried out after that.

X-ray Diffractometry

Each of the phosphors obtained in Examples and Comparative Examples 1 was subjected to X-ray diffractometry under the above-described conditions. As a result, in each example, the X-ray diffraction pattern matched the pattern of PDF data No. 01-077-1189 that is derived from $SrGa_2S_4$. Also, diffraction peaks were observed in a range of $2\theta =$ 27.6°or more and 28.3° or less and a range of $2\theta = 28.45$°or more and 28.75° or less that are presumed to be derived from $BaGa_4S_7$. However, a diffraction peak that is presumed to be derived from $Sr_2Ga_2S_5$ was not observed.

On the other hand, in Comparative Example 1, a diffraction peak that is presumed to be derived from $SrGa_2S_4$ was observed, but a diffraction peak that is presumed to be derived from $BaGa_4S_7$ was not observed. Also, in Comparative Example 1, a diffraction peak that is presumed to be derived from $Sr_2Ga_2S_5$ was observed.

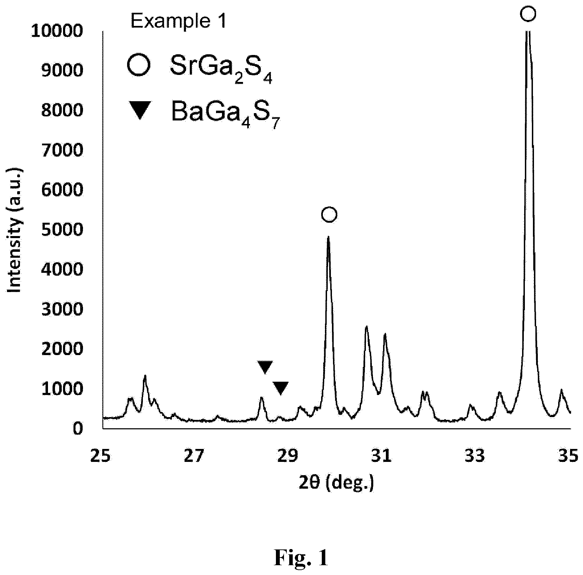

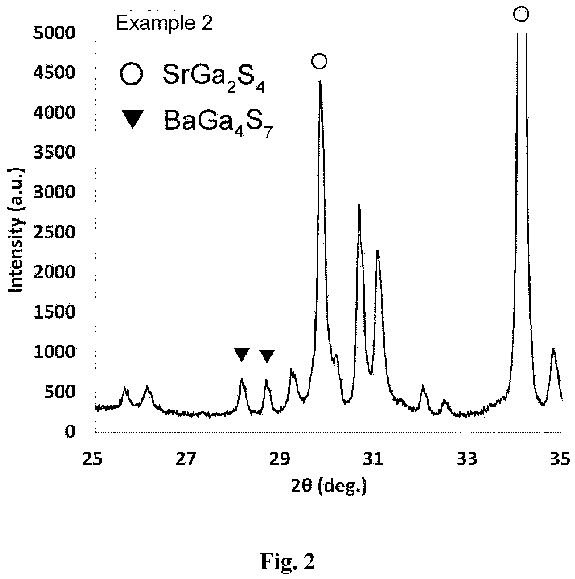

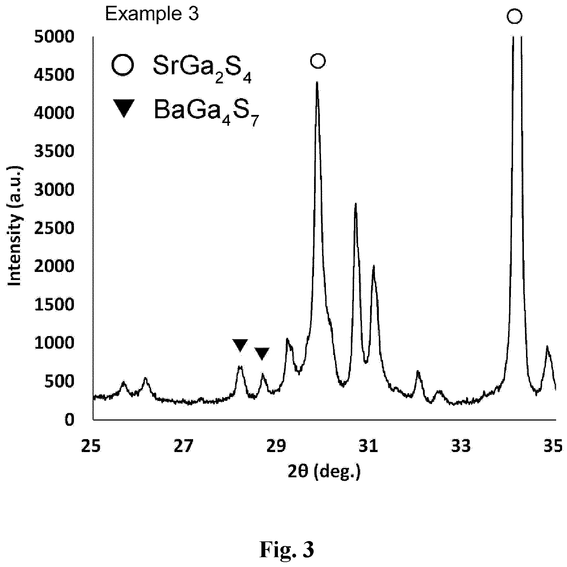

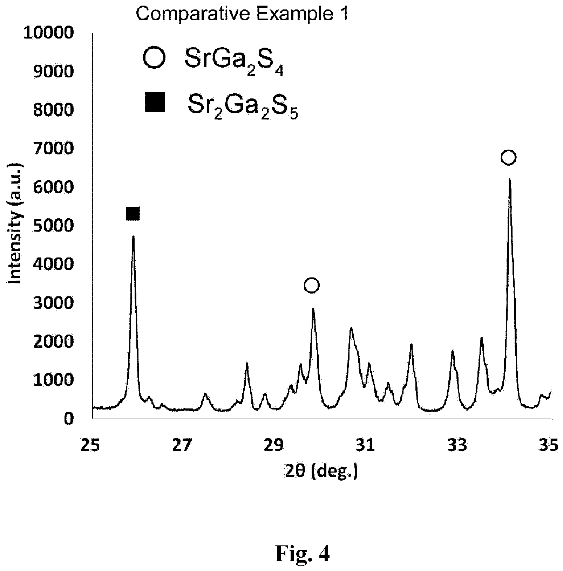

The X-ray diffraction charts of the phosphors obtained in Examples and Comparative Example 1 are shown in FIGS. 1 to 4, respectively.

Also, diffraction peak values Ia, Ib, Ic, and Id, and intensity ratios Ia/Ic, Ib/Ic, and Ib/Id are shown in Table 1 given below.

Measurement of Absorption Rate and Internal Quantum Efficiency of Phosphor

The absorption rate and the internal quantum efficiency of each of the phosphors in the form of a powder obtained in Examples and Comparative Examples were measured in the manner described below.

More specifically, the absorption rate and the internal quantum efficiency were measured in accordance with a solid quantum efficiency calculation program using a spectrofluorometer FP-8500 and an integrating sphere unit ISF-834 (available from JASCO Corporation). The spectrofluorometer was calibrated using a substandard light source and Rhodamine B.

Calculation formulas for calculating the absorption rate, the internal quantum efficiency, and the external quantum efficiency of a phosphor measured using excitation light with a wavelength of 450 nm are shown below. The calculation formulas are based on those described in the manual of FWSQ-6-17(32) solid quantum efficiency calculation program available from JASCO Corporation.

The results of the absorption rate and the internal quantum efficiency are shown in Table 1 given below.

$P_1(\lambda)$ represents a standard white plate spectrum, $P_2(\lambda)$ represents a sample spectrum, and $P_3(\lambda)$ represents an indirect excitation sample spectrum.

Area $L_1$, which is an area where the spectrum $P_1(\lambda)$ is surrounded by an excitation wavelength range of 461 nm to 481 nm (see a formula (i) given below), is defined as excitation intensity.

Area $L_2$, which is an area where the spectrum $P_2(\lambda)$ is surrounded by an excitation wavelength range of 461 nm to 481 nm (see a formula (ii) given below), is defined as sample scattering intensity.

Area $E_2$, which is an area where the spectrum $P_2(\lambda)$ is surrounded by an excitation wavelength range of 482 nm to 648.5 nm (see a formula (iii) given below), is defined as sample fluorescence intensity.

Area $L_3$, which is an area where the spectrum $P_3(\lambda)$ is surrounded by an excitation wavelength range of 461 nm to 481 nm (see a formula (iv) given below) is defined as indirect scattering intensity.

Area $E_3$, which is an area where the spectrum $P_3(\lambda)$ is surrounded by an excitation wavelength range of 482 nm to 648.5 nm (see a formula (v) given below), is defined as indirect fluorescence intensity.

[Math. 1]

$$L_1 = \int_{461}^{481} P_1(\lambda)d\lambda \qquad \cdots (i)$$

$$L_2 = \int_{461}^{481} P_2(\lambda)d\lambda \qquad \cdots (ii)$$

$$E_2 = \int_{482}^{648.5} P_2(\lambda)d\lambda \qquad \cdots (iii)$$

$$L_3 = \int_{461}^{481} P_3(\lambda)d\lambda \qquad \cdots (iv)$$

$$E_3 = \int_{482}^{648.5} P_3(\lambda)d\lambda \qquad \cdots (v)$$

As shown by a formula (vi) given below, the absorption rate is a ratio of incident light in an amount corresponding to a reduction amount by the sample relative to excitation light.

As shown by a formula (vii) given below, the external quantum efficiency $\varepsilon_{ex}$ is a value obtained by dividing a photon count $N_{em}$, which is the number of fluorescent photons emitted from the sample, by a photon count $N_{ex}$, which is the number of fluorescent photons emitted to the sample.

As shown by a formula (viii) given below, the internal quantum efficiency $\varepsilon_{in}$ is a value obtained by dividing a photon count $N_{em}$, which is the number of fluorescent photons emitted from the sample by a photon count $N_{abs}$, which is the number of excitation photons absorbed by the sample.

[Math. 2]

$$A = \frac{L_1 - L_2}{L_1} \qquad \cdots (vi)$$

$$\varepsilon_{ex} = \frac{N_{em}}{N_{ex}} = \frac{E_2 - \frac{L_2}{L_1}E_3}{L_1} \qquad \cdots (vii)$$

$$\varepsilon_{in} = \frac{N_{em}}{N_{abs}} = \frac{E_2 - \frac{L_2}{L_1}E_3}{L_1 - L_2} \qquad \cdots (viii)$$

[Table 1]

| | Composition ratio of phosphor | | | | | Sintering condition | X-ray diffraction measurement value and intensity ratio | | | | | | | Light emission characteristics | |
|---|---|---|---|---|---|---|---|---|---|---|---|---|---|---|---|
| | Molar ratio of element M, luminescent center element A, and element Ga | | | | $X_{Ga}/(X_M + X_A)$ | | | | | | | | | | |
| Type of element | Ba | Sr | Eu | Ga | | Temp. [°C] | Ia [a.u.] | Ib [a.u.] | Ic [a.u.] | Id [a.u.] | Ia/Ic | Ib/Ic | Ib/Id | Absorption rate | Internal quantum efficiency |
| Comparative Ex. 1 | 0.22 | 0.65 | 0.13 | 1.50 | 1.50 | 1100 | 1432 | 1032 | 4731 | 662 | 0.30 | 0.22 | 1.56 | 79% | 25% |
| Example 1 | 0.22 | 0.66 | 0.12 | 1.84 | 1.84 | 1100 | 647 | 789 | 1342 | 340 | 0.48 | 0.59 | 2.32 | 80% | 46% |
| Example 2 | 0.22 | 0.65 | 0.13 | 2.10 | 2.10 | 1100 | 668 | 653 | 553 | 254 | 1.21 | 1.18 | 2.57 | 76% | 65% |
| Example 3 | 0.22 | 0.65 | 0.13 | 2.30 | 2.30 | 1100 | 696 | 599 | 486 | 293 | 1.43 | 1.23 | 2.04 | 75% | 65% |
| Comparative Ex. 2 | 0.22 | 0.65 | 0.13 | 2.50 | 2.50 | 1100 | - | - | - | - | - | - | - | - | - |

**Industrial Applicability**

According to the present invention, it is possible to provide a phosphor that has an internal quantum efficiency higher than conventional phosphors. Also, according to the present invention, it is possible to produce the phosphor in a stable manner.

**Claims**

1. A phosphor comprising:

   - a crystal phase represented by a formula (1): $MGa_2S_4$,
   where M includes at least one element selected from the group consisting of Ba, Sr, and Ca;
   - a crystal phase represented by a formula (2): $MGa_4S_7$,
   where M includes at least one element selected from the group consisting of Ba, Sr, and Ca; and
   - an element A that functions as a luminescent center.

2. A phosphor comprising:

   - a crystal phase represented by a formula (1): $MGa_2S_4$,
   where M includes at least one element selected from the group consisting of Ba, Sr, and Ca; and
   - an element A that functions as a luminescent center,

   wherein, the phosphor has diffraction peaks observed in a range of $2\theta$ = 27.55° or more and 28.30° or less and a range of $2\theta$ = 28.45° or more and 28.75° or less in an X-ray diffraction pattern obtained through measurement that uses CuKα rays performed using an X-ray diffractometer.

3. The phosphor according to claim 1 or 2, wherein a ratio $X_{Ga}/(X_M + X_A)$ is 1.6 or more and 2.6 or less,

   where $X_M$ represents a molar amount of the element M contained in the phosphor,
   $X_A$ represents a molar amount of the element A contained in the phosphor
   $X_{Ga}$ represents a molar amount of Ga contained in the phosphor.

4. The phosphor according to any one of claims 1 to 3, wherein a ratio Ia/Ic is 0.4 or more, the ratio Ia/Ic being a ratio of a maximum diffraction peak value Ia observed in a range of $2\theta$ = 27.9° or more and 28.36° or less relative to a maximum diffraction peak value Ic observed in a range of $2\theta$ = 25.8° or more and 26.1° or less in an X-ray diffraction pattern obtained through measurement that uses CuKα rays performed using an X-ray diffractometer.

5. The phosphor according to any one of claims 1 to 4, wherein a ratio Ib/Ic is 0.4 or more, the ratio Ib/Ic being a ratio of a maximum diffraction peak value Ib observed in a range of $2\theta$ = 28.4° or more and 28.86° or less relative to a maximum diffraction peak value Ic observed in a range of $2\theta$ = 25.8° or more and 26.1° or less in an X-ray diffraction pattern obtained through measurement that uses CuKα rays performed using an X-ray diffractometer.

6. The phosphor according to any one of claims 1 to 5, wherein the element A that functions as the luminescent center includes at least one element selected from the group consisting of Eu, Ce, Mn, and Sm.

7. A method for producing a phosphor, the method comprising:

   - preparing an ingredient composition that contains: Ga, S, and M; and an element A that functions as a luminescent center,
   where M includes at least one element selected from the group consisting of Ba, Sr, and Ca, and
   - sintering the ingredient composition while a portion of the ingredient composition is melted.

8. A method for producing a phosphor, the method comprising:

   - preparing an ingredient composition that contains: Ga, S, and M; and an element A that functions as a luminescent center,
   where M includes at least one element selected from the group consisting of Ba, Sr, and Ca, and

- sintering the ingredient composition to produce a compound represented by a formula (1): $MGa_2S_4$, where M includes at least one selected from the group consisting of Ba, Sr, and Ca and a compound represented by a formula (2): $MGa_4S_7$, where M includes at least one element selected from the group consisting of Ba, Sr, and Ca.

9. A light emitting element comprising: the phosphor according to any one of claims 1 to 6; and a resin.

10. A light emitting device comprising: the phosphor according to any one of claims 1 to 6; and an excitation source.

**Fig. 1**

**Fig. 2**

**Fig. 3**

Fig. 4

## INTERNATIONAL SEARCH REPORT

International application No.

**PCT/JP2021/045661**

### A. CLASSIFICATION OF SUBJECT MATTER

*C09K 11/08*(2006.01)i; *C09K 11/62*(2006.01)i
FI: C09K11/62; C09K11/08 B

According to International Patent Classification (IPC) or to both national classification and IPC

### B. FIELDS SEARCHED

Minimum documentation searched (classification system followed by classification symbols)

C09K11/08; C09K11/62

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2011/033830 A1 (MITSUI MINING & SMELTING CO., LTD.) 24 March 2011 (2011-03-24) <br> paragraphs [0042]-[0045], [0048]-[0051] | 1-10 |
| X | JP 2007-112950 A (CANON INC.) 10 May 2007 (2007-05-10) <br> paragraphs [0040]-[0048] | 1-10 |
| A | JP 2017-88719 A (SAKAI CHEMICAL INDUSTRY CO., LTD.) 25 May 2017 (2017-05-25) <br> entire text, all drawings | 1-10 |
| A | JP 7-242869 A (MITSUI MINING & SMELTING CO., LTD.) 19 September 1995 (1995-09-19) <br> entire text, all drawings | 1-10 |
| A | JP 2013-77825 A (DEXERIALS CORP.) 25 April 2013 (2013-04-25) <br> entire text, all drawings | 1-10 |

☐ Further documents are listed in the continuation of Box C.    ☑ See patent family annex.

| | |
|---|---|
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **04 February 2022** | **22 February 2022** |

| Name and mailing address of the ISA/JP | Authorized officer |
|---|---|
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (January 2015)

INTERNATIONAL SEARCH REPORT

Information on patent family members

International application No.

**PCT/JP2021/045661**

| Patent document cited in search report | | | Publication date (day/month/year) | Patent family member(s) | | | Publication date (day/month/year) |
|---|---|---|---|---|---|---|---|
| WO | 2011/033830 | A1 | 24 March 2011 | US 2012/0018674 A1 paragraphs [0080]-[0093], [0098]-[0102], table 1 EP 2479237 A1 KR 10-2012-0002542 A CN 102471684 A | | | |
| JP | 2007-112950 | A | 10 May 2007 | US 2007/0090748 A1 paragraphs [0057]-[0066] CN 1958716 A | | | |
| JP | 2017-88719 | A | 25 May 2017 | (Family: none) | | | |
| JP | 7-242869 | A | 19 September 1995 | (Family: none) | | | |
| JP | 2013-77825 | A | 25 April 2013 | (Family: none) | | | |

Form PCT/ISA/210 (patent family annex) (January 2015)

**EP 4 317 363 A1**

**Patent documents cited in the description**

- US 2011114985
- US 2012018674